# EUROPEAN PATENT SPECIFICATION

(11) **EP 2 015 376 B1**
(45) Date of publication and mention of the grant of the patent: **07.03.2012**
(21) Application number: 07741816.8
(22) Date of filing: 11.04.2007
(51) Int. Cl.: F16K 13/10, F16K 31/06, G02B 26/02, G03B 9/02, G05D 7/00, G05D 7/01, H01L 41/12, G02B 27/09

(54) **METHOD OF CONTROLLING REGULATING HOLE**
VERFAHREN ZUR STEUERUNG EINES REGULIERUNGSLOCHS
PROCÉDÉ DE CONTRÔLE D'UN TROU DE RÉGULATION

(30) Priority: 14.04.2006 JP 2006111598
(43) Date of publication of application: 14.01.2009
(73) Proprietor: Showa Denko K.K., Tokyo 105-8518 (JP); The Doshisha, Kyoto-shi, Kyoto 602-8580 (JP)
(72) Inventor: YAMAGUCHI, Hiroshi, Kyotanabe-shi, Kyoto 610-0394 (JP); ENOMOTO, Masatoshi, Oyama-shi, Tochigi 323-8678 (JP)
(74) Representative: Viering, Jentschura & Partner
(86) International application number: PCT/JP2007/058380
(87) International publication number: WO 2007/119858

(56) References cited:
- EP-A- 1 219 313
- DE-B- 1 106 133
- DE-U1- 29 913 326
- JP-A- 02 271 180
- JP-A- 06 011 063
- JP-A- 09 063 840
- JP-A- 59 231 279
- JP-A- 63 053 372
- JP-A- 2005 147 314
- US-A- 3 982 722

## Description

This application claims priority to Japanese Patent Application No. 2006-111598 filed on April 14, 2006.

### TECHNICAL FIELD

The present invention relates to a method of controlling a regulating hole according to the preamble of claim 1, to a control device for a regulating hole according to the preamble of claim 8, and to a method of producing a partition wall according to the preamble of claim 15.

### BACKGROUND ART

Conventionally, as a method of controlling a flow rate of fluid passing through a tubular passage, a mechanical control method, such as, e.g., a control method using a needle valve, has been typically used.

In this method, however, there are drawbacks that the mechanical slide movements cause wear of the valve, varying control characteristics thereof across the ages, which in turn may result in loss of control.

In the meantime, magnetic fluid containing magnetic particles is used as a damper for damping vibrations of a CD player (see, e.g., Patent Documents 1 and 2).
[Patent Document 1] Japanese Unexamined Laid-open Patent Publication No. 2005-180612
[Patent Document 2] Japanese Unexamined Laid-open Patent Publication No. 2001-291609

A method of controlling a regulating hole according to the preamble of claim 1, a control device for a regulating hole according to the preamble of claim 8, and a method of producing a partition wall according to the preamble of claim 15 are known, e.g., from DE 1106133 B.

JP 59 231279 A discloses a variable orifice using magnetic fluid, with a magnetic fluid provided in a doughnut like bag section provided on the inner circumferential wall of a pipe.

### DISCLOSURE OF THE INVENTION

### PROBLEMS TO BE SOLVED BY THE INVENTION

Magnetic fluid containing magnetic particles, however, has fluidity which is inconvenience in handling, and vaporizes/volatilizes by the prolonged use, resulting in gradual volume decrease. By these reasons, the control device for tampers using magnetic fluid varies control characteristics thereof across the ages, which in turn may result in loss of control.

The present invention was made in view of the aforementioned technical background, and the purpose of the invention is to provide a method of controlling a regulating hole for regulating an amount of light, a flow rate of fluid, or a pressure of the fluid passing through a tubular passage, a device for controlling a regulating hole for use in the aforementioned control method, and a production method of a partition wall used in the control device.

The other purposes and advantages of the present invention will be apparent from the following preferred embodiments.

### MEANS TO SOLVE THE PROBLEMS

[1] A method of controlling a regulating hole, wherein a partition wall is transversely disposed in a tubular passage through which light or fluid passes, the partition wall being provided with a regulating hole for regulating an amount of the light, a flow rate of the fluid, or a pressure of the fluid so that the regulating hole penetrates the partition wall in an axial direction, and
   wherein magnetic field gradient is generated in a radial direction in the tubular passage to thereby change an opening degree of the regulating hole.
   The partition wall is formed by a viscoelastic solid containing magnetic particles being dispersed in the viscoelastic solid and contained in the viscoelastic solid in a fixed manner.
[2] The method of controlling a regulating hole as recited in the aforementioned Item 1, wherein the magnetic particle is set to 500 µm or less in particle size.
[3] The method of controlling a regulating hole as recited in the aforementioned Item 1 or 2, wherein the viscoelastic solid is one type or two or more types of rubbers selected from the group consisting of silicone rubber, urethane rubber, propylene rubber, polyethylene rubber, neoprene rubber, and natural rubber.
[4] The method of controlling a regulating hole as recited in any one of the aforementioned Items 1 to 3, wherein the magnetic particle is one type or two or more types of particles selected from the group consisting of carbonyl iron particles, ferrite particles, and magnetite particles.
[5] The method of controlling a regulating hole as recited in any one of the aforementioned Items 1 to 4, wherein, when a value obtained by dividing a volume of the magnetic particles by a total volume of the magnetic particles and the viscoelastic solid is defined as a rate of content of the magnetic particles in the partition wall, the rate of content is set so as to fall within the range of 15 to 52 volume %.
[6] The method of controlling a regulating hole as recited in any one of the aforementioned Items 1 to 5, wherein the partition wall is formed by a silicone rubber containing carbonyl iron particles obtained by mixing mother liquid of the silicone rubber, its hardening solution, and carbonyl iron particles falling within the range of 1 : 0.1-1.5 : 1.3-8 in mass ratio and then heat hardening the mixture.
[7] The method of controlling a regulating hole as recited in any one of the aforementioned Items 1 to 6, wherein the magnetic field gradient is generated by a coil disposed at an outside of the tubular passage so as to surround the partition wall in a circumferential direction.
[8] A control device for a regulating hole, comprising:
   a tubular passage through which light or fluid passes;
   a partition wall transversely disposed in the tubular passage and provided with a regulating hole for regulating an amount of the light, a flow rate of the fluid, or a pressure of the fluid so that the regulating hole penetrates the partition wall in an axial direction; and
   a magnetic field gradient generating means for generating magnetic field gradient in a radial direction in the tubular passage.
   The partition wall is formed by a viscoelastic solid containing magnetic particles being dispersed in the viscoelastic solid and contained in the viscoelastic solid in a fixed manner.
[9] The control device for a regulating hole as recited in the aforementioned Item 8, wherein the magnetic particle is set to be 500 µm or less in particle size.
[10] The control device for a regulating hole as recited in the aforementioned Item 8 or 9, wherein the viscoelastic solid is one type or two or more types of rubbers selected from the group consisting of silicone rubber, urethane rubber, propylene rubber, polyethylene rubber, neoprene rubber, and natural rubber.
[11] The control device for a regulating hole as recited in any one of the aforementioned Items 8 to 10, wherein the magnetic particle is one type or two or more types of particles selected from the group consisting of carbonyl iron particles, ferrite particles, and magnetite particles.
[12] The control device for a regulating hole as recited in any one of the aforementioned Items 8 to 11, wherein, when a value obtained by dividing a volume of the magnetic particles by a total volume of the magnetic particles and the viscoelastic solid is defined as a rate of content of the magnetic particles in the partition wall, the rate of content is set so as to fall within the range of 15 to 52 volume %.
[13] The control device for a regulating hole as recited in any one of the aforementioned Items 8 to 12, wherein the partition wall is formed by a silicone rubber containing carbonyl iron particles obtained by mixing mother liquid of the silicone rubber, its hardening solution, and carbonyl iron particles falling within the range of 1 : 0.1-1.5 : 1.3-8 in mass ratio and then heat hardening the mixture.
[14] The control device for a regulating hole as recited in any one of the aforementioned Items 8 to 13, wherein the magnetic field gradient generating means is configured to generate magnetic field gradient by a coil disposed at an outside of the tubular passage so as to surround the partition wall in a circumferential direction.
[15] A method of producing a partition wall for use in a control device for a regulating hole, the control device comprising:
   a tubular passage through which light or fluid passes;
   a partition wall transversely disposed in the tubular passage and provided with a regulating hole for regulating an amount of the light, a flow rate of the fluid, or a pressure of the fluid so that the regulating hole penetrates the partition wall in an axial direction; and
   a magnetic field gradient generating means for generating magnetic field gradient in a radial direction in the tubular passage,
   wherein the partition wall is formed by silicone rubber containing carbonyl iron particles obtained by mixing mother liquid of the silicone rubber, its hardening solution, and carbonyl iron particles falling within the range of 1 : 0.1-1.5 : 1.3-8 in mass ratio and then heat hardening the mixture.
   The partition wall is formed by a viscoelastic solid containing magnetic particles being dispersed in the viscoelastic solid and contained in the viscoelastic solid in a fixed manner.

### EFFECTS OF THE INVENTION

The present invention exerts the following effects.

In the invention [1], by generating the magnetic field gradient in the radial direction in the tubular passage, the opening degree of the regulating hole can be changed. Therefore, even in the case of repeatedly changing the opening degree of the regulating hole, almost no wear of the partition wall occurs. Furthermore, the partition wall is formed by a viscoelastic solid, which does not cause volatilization or vaporization. Therefore, the regulating hole can be controlled over a long period of time.

Furthermore, the partition wall formed by a viscoelastic solid is easy to handle as compared with a partition wall formed by magnetic fluid, and the installation work of the partition wall in the tubular passage can be easily performed.

In the invention [2], at the time of producing the partition wall, the magnetic particles can be evenly dispersed in the viscoelastic solid. Therefore, a partition wall in which magnetic particles are evenly dispersed can be produced. By using this partition wall, the control of the regulating hole can be performed assuredly.

In the invention [3], the partition wall can be assuredly set to have elasticity appropriate for changing the opening degree of the regulating hole. Thus, the control of the regulating hole can be performed assuredly.

In the invention [4], the partition wall can be assuredly set to have magnetism appropriate for changing the opening degree of the regulating hole. Thus, the control of the regulating hole can be performed assuredly.

In the invention [5], the partition wall can be assuredly set to have elasticity and magnetism appropriate for changing the opening degree of the regulating hole. Thus, the control of the regulating hole can be performed more assuredly.

In the invention [6], the partition wall can be assuredly set to have elasticity and magnetism appropriate for changing the opening degree of the regulating hole. Thus, the control of the regulating hole can be performed assuredly.

In the invention [7], the opening degree of the regulating hole can be changed assuredly.

In the inventions [8] to [14], a control device for a regulating hole preferably used in a control method of a regulating hole according to the present invention can be provided.

In the invention [15], a partition wall used in the control device for a regulating hole according to the present invention can be produced assuredly.

### BRIEF EXPLANATION OF THE DRAWINGS

Fig. 1 is a cross-sectional view of a control device for a regulating hole according to a first embodiment of the present invention.
Fig. 2 is a schematic explanatory view of the control device.
Fig. 3 is a perspective view of the partition wall of the control device.
Fig. 4A is a schematic cross-sectional view showing the partition wall in a state before generating magnetic field gradient in a tubular passage of the control device.
Fig. 4B is a schematic cross-sectional view showing the partition wall in a state after generating magnetic field gradient in the tubular passage of the control device.
Fig. 4C is a schematic cross-sectional view showing the partition wall in another deformed state after generating magnetic field gradient in the tubular passage of the control device.
Fig. 5A is a perspective view showing a first modification of the partition wall.
Fig. 5B is a perspective view showing a second modification of the partition wall.
Fig. 5C is a perspective view showing a third modification of the partition wall.
Fig. 5D is a perspective view showing a fourth modification of the partition wall.
Fig. 5E is a perspective view showing a fifth modification of the partition wall.
Fig. 5F is a perspective view showing a sixth modification of the partition wall.
Fig. 5G is a perspective view showing a seventh modification of the partition wall.
Fig. 6 is a schematic cross-sectional view of a control device for a regulating hole according to a second embodiment of the present invention.
Fig. 7 is a schematic view of a control device for a regulating hole used in Example (experimental example) of the present invention.
Fig. 8 is a graph showing a representative relation between the magnetic field intensity Hz* and the opening area S of the regulating hole.
Fig. 9 shows photographs of regulating holes took in several representative magnetic field intensities Hz*.
Fig. 10 is an explanatory view of Fig. 9A.

### DESCRIPTION OF REFERENCE NUMERALS

1B, 1C...control device for a regulating hole
2...tubular member
3...tubular passage
5...partition wall
6...regulating hole
7...magnetic field gradient generating means
8...coil
9...power source
11...cooling jacket (cooling means)
G...fluid

### BEST MODE FOR CARRYING OUT THE INVENTION

Next, some preferred embodiments of the present invention will be explained with reference to the attached drawings.

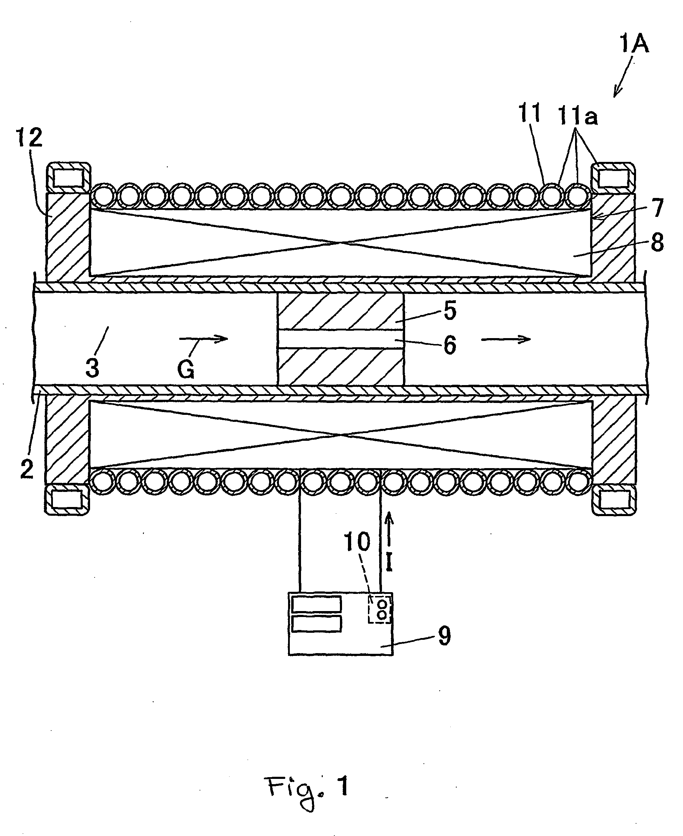

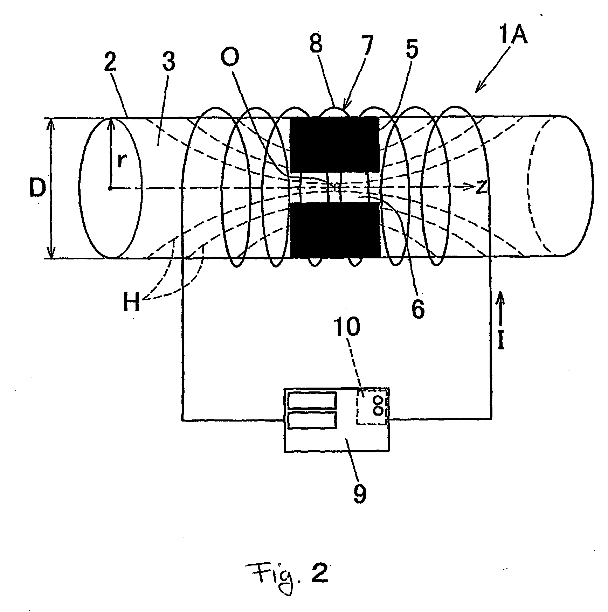

Fig. 1 is a schematic cross-sectional view of a control device 1A for a regulating hole according to a first embodiment of the present invention. Fig. 2 is a schematic explanatory view of this control device 1A.

This control device 1A is, as shown in Fig. 1, equipped with a tubular member 2, a partition wall 5 and a magnetic field gradient generating means 7.

In detail, the tubular member 2 is a tubular member round in cross-section. Therefore, the tubular passage 3 of this tubular member 2 is round in cross-section. Through this tubular passage 3, fluid G, such as, e.g., liquid (e.g., water, oil, or liquid fuel) or gas (e.g., air, or gaseous fuel) passes along the axial direction. It should be noted that the present invention does not limit the type of the fluid G passing through the tubular passage 3.

The tubular member 2 is made of a magnetic field permeable material. Specifically, it is made of, for example, plastics (e.g., acrylic resin, vinyl chloride resin, or polytetrafluoroethylene resin) or a non-magnetic substance, such as, e.g., ceramics.

The inner diameter of the tubular member 2, i.e., the diameter D (see Fig. 2) of the tubular passage 3, is set so as to fall within the range of, for example, from 12 to 24 mm. The present invention does not require that the diameter D falls within this range.

In Fig. 2, the r-axis is an axis in the radial direction of the tubular passage 3, and the z-axis is an axis passing through the central axis of the tubular passage 3. The origin O of the z-axis is set at the axial intermediate position of the partition wall 5 on the central axis of the tubular passage 3.

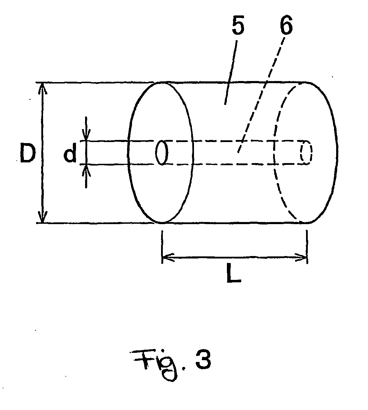

The partition wall 5 has a columnar shape as shown in Fig. 3. This partition wall 5 is transversally disposed at the axial intermediate position in the tubular passage 3 as shown in Fig. 1. Thus, the tubular passage 3 is partitioned into an upstream side and a downstream side by the partition wall 5. The diameter of the partition wall 5 is set to be the same as or slightly larger than the diameter D of the tubular passage 3.

The length L (see Fig. 3) of the partition wall 5 is set so as to fall within the range of, for example, from 9 to 15 mm. It should be noted that the present invention does not require that the length L falls within the aforementioned range.

As shown in Fig. 1, a regulating hole 6 for regulating the flow rate or the pressure of the fluid G passing through the tubular passage 3 is provided at the central portion of the partition wall 5 in such a manner that the regulating hole 6 straightly penetrates the partition wall 5 in the axial direction of the tubular passage 3. This regulating hole 6 functions as, e.g., an orifice. The control device 1A of this first embodiment is used to control this regulating hole 6.

In this embodiment, the cross-sectional shape of the regulating hole 6 is circular, and the diameter d and the opening area S of the regulating hole 6 are each set to be constant along the axial direction of the tubular passage 3.

The diameter d of the regulating hole 6 is set so as to fall within the range of, for example, from 0.1 to 1 mm. The present invention, however, does not require that the diameter d falls within this range.

The partition wall 5 is made of a viscoelastic solid containing magnetic particles, and therefore is elastically deformable. The magnetic particles are dispersed evenly or generally evenly in the viscoelastic solid and contained in the viscoelastic solid in a fixed manner. The partition wall 5 is configured such that it can be deformed elastically when magnetic field gradient is generated in the tubular passage 3 in the radial direction (i.e., in the r-direction).

As shown in Fig. 1, in a state in which this partition wall 5 is disposed in the tubular passage 3, the circumferential surface of the partition wall 5 is in face-to-face contact with the circumferential surface of the tubular passage 3 (i.e., the inner circumferential surface of the tubular member 2) along the entire circumference. In the present invention, the partition wall 5 can be disposed in the tubular passage 3 in a state in which the circumferential surface is in non-press-fit contact with the circumferential surface of the tubular passage 3, or the partition wall 5 can be disposed in the tubular passage 3 in a state in which the circumferential surface is bonded to the circumferential surface of the tubular passage 3 with, e.g., adhesive agent. Alternatively, the partition wall 5 can be inserted into the tubular passage 3 in a compressed state to be disposed in the tubular passage 3 in a state in which the circumferential surface of the partition wall 5 is press-secured to the circumferential surface of the tubular passage 3 by the elastic restoring force accumulated in the partition wall 5.

It is preferable that the viscoelastic solid is one type or two or more types of rubbers selected from the group consisting of silicone rubber, urethane rubber, propylene rubber, polyethylene rubber, neoprene rubber, and natural rubber. In detail, it is preferable that the viscoelastic solid is a rubber made of one of the rubbers selected from the group or made by mixing two or more types of the rubbers selected from the group. The use of such viscoelastic solid as the structural material of the partition wall 5 assuredly enables the partition wall 5 to have elasticity suitable for changing the opening degree of the regulating hole 6, which in turn enables assured control of the regulating hole 5. Each rubber can be used in a gel state.

It is preferable that the tearing strength of the viscoelastic solid at 100°C falls within the range of, for example, from 10 to 30 kN/m². It should be noted, however, that the present invention does not require that the tearing strength falls within the aforementioned range.

The use of viscoelastic solid as the structural material of the partition wall 5 enables minute changes of the opening degree of the regulating hole 6, which in turn enables assured control of the regulating hole 6.

As the magnetic particles, it is preferable to use, for example, one or two or more particles selected from the group consisting of ferromagnetic particles, diamagnetic particles, antiferromagnetic particles and paramagnetic particles. In detail, it is preferable that the magnetic particles are one type of the particles selected from the group or a mixture of two or more types of the particles selected from the group.

Furthermore, it is preferable that the magnetic particle is one type or two or more types of particles selected from the group consisting of carbonyl iron particles, ferrite particles, and magnetite particles. In detail, the magnetic particles are preferably one type of particles or particles obtained by mixing two or more types of particles selected from the group.

The magnetic particle is preferably set to be 500 µm or less in particle size. The particle size denotes an average particle size of the magnetic particles. The particle size of 500 µm or less enables uniform dispersion of the magnetic particles in the viscoelastic solid at the time of producing the partition wall 5. As a result, a partition wall 5 in which magnetic particles are uniformly dispersed can be produced. The use of such a partition wall 5 enables assured control of the regulating hole 6. It is more preferable that the particle size is set to be 10 µm or less.

On the other hand, the lower limit of the particle size of the magnetic particle is not specifically limited, and can be any size as long as it exceeds 0 µm. Specifically, it is preferable that the particle size is 1 µm or more since it is possible to produce and obtain magnetic particles at low cost.

In cases where the magnetic particle is 10 nm or less in particle size, e.g., in the case of the magnetite particle having a particle size of 10 nm or less, there is a possibility that it can be used as a superparamagnetic particle. The use of the superparamagnetic particle has the following advantages. That is, in cases where the partition wall 5 is formed by a viscoelastic solid containing ferromagnetic particles, repeated applications of magnetic fields to the partition wall 5 may generate heat. On the other hand, in cases where the partition wall 5 is formed by a viscoelastic solid containing superparamagnetic particles, there is an advantage that no such heat will be generated. Since the ferromagnetic particles cause remnant magnetization, the former partition wall 5 using ferromagnetic particles has somewhat problems in response. On the other hand, since superparamagnetic particles does not almost or not at all cause remnant magnetization, the latter partition wall 5 using superparamagnetic particles has advantages that the response is superior to the former partition wall 5.

The present invention, however, does not require that the particle size of the magnetic particle falls within the aforementioned range.

The magnetic particle can have a spherical shape, a bar-shape, a needle-shape, or any other shape.

In this partition wall 5, when the value obtained by dividing the volume of the magnetic particles by the total volume of the magnetic particles and the viscoelastic solid is defined as the rate of content (volume content) of the magnetic particles in the partition wall 5, it is preferable that the rate of content falls within the range of 15 to 52 volume %. This rate of content can be calculated by [A/(A+B)]x100, where the volume of the magnetic particles is A and the volume of the viscoelastic solid is B.

By setting the rate of content within the aforementioned range, the elasticity and magnetism of the partition wall 5 each can be assuredly set to a value appropriate for changing the opening degree of the regulating hole 6. In detail, if the content is less than 15 volume %, the amount of the magnetic particles is too small, resulting in small deformation of the partition wall 5, which in turn may make it difficult to change the opening degree of the regulating hole 6. On the other hand, if the content exceeds 52 volume %, there is a possibility that the deformability of the partition wall 5 cannot follow the intensity of the magnetic field. This may cause breakage of the partition wall 5. The more preferable content range is 25 to 30 volume %. In the present invention, however, does not require that the rate of content falls within the aforementioned range.

In cases where the partition wall 5 is formed by silicone rubber (more specifically, silicone gel) containing carbonyl iron particles as the magnetic particles, an example of the preferable production method of the partition wall 5 will be as follows.

A mother liquid of silicone rubber, its hardening solution, and carbonyl iron particles falling within the rang of 1 : 0.1-1.5 : 1.3-8 in mass ratio are uniformly agitated and mixed with an agitation means, such as, e.g., an agitation mixer, while defoaming under reduced pressure. Thereafter, this mixture is poured into a molding cavity of a predetermined forming die. At this time, in the molding cavity, a thin rod-shaped core for forming a regulating hole is disposed along the axial direction. As the material for the molding die, plastic, such as, e.g., acrylic resin, can be preferably used. It is especially preferable that the mixture ratio (i.e., compounding ratio) of the mother liquid of the silicone rubber, its hardening solution, and carbonyl iron particles falls within the range of 1 : 1 : 1.3-8 in mass ratio.

Next, the mixture in the molding cavity is heated to be hardened in the temperature range of, e.g., 30 to 70°C with a heating means, such as, e.g., a hot-air heater. Thereafter, the hardened material is taken out from the molding cavity, and further subjected to a trimming work if needed. Thus, a partition wall 5 formed by silicone rubber containing carbonyl iron particles can be produced.

The magnetic field gradient generating means 7 is configured to generate magnetic field gradient in the radial direction (i.e., in the r-direction) in the tubular passage 3, and includes a coil (more specifically, an electromagnetic coil) 8 and a power source 9. This magnetic field gradient generating means 7 is configured to generate magnetic field gradient in the tubular passage 3 by the coil 8.

The coil 8 is formed into, e.g., a round shape. More specifically, the coil 8 is formed by, e.g., a finite-length solenoid coil. The coil 8 is disposed coaxially with the central axis of the tubular passage 3 so that the coil 8 circumferentially surrounds the partition wall 5 at the outside of the tubular passage 3 (i.e., at the outside of the tubular member 2). In other words, the tubular passage 3 and the partition wall 5 is disposed at the inside of the coil 8. The length of this coil 8 (more specifically, the axial direction of the coil 8) is set so as to fall within the range of, for example, 4L to 8L (L: the length of the partition wall 5). It should be noted, however, that the present invention does not require that the length of the coil 8 falls within this range.

The power supply 9 is configured to supply current to the coil 8, more specifically to supply direct current to the coil 8, and is connected to the coil 8. This power supply 9 is provided with a current regulating means 10, such as, e.g., a variable resistor, for regulating supply current to the coil 8. For example, it can supply direct current I falling within the range of 0 to 30 A. This current regulating means 10 can be considered as a means for changing the magnitude of the magnetic field gradient in the radial direction in the tubular passage 3.

Furthermore, the magnetic field gradient generating means 7 is equipped with a copper coil holder 12 for holding the coil 8 and a cooling jacket 11 as a means for cooling the coil 8 and the coil holder 12.

The cooling jacket 11 has a cooling pipe 11a mounted on the outer periphery of the coil 8 and the outer periphery of the coil holder 12. It is configured to cool the coil 8 and the coil holder 12 by passing a cooling liquid, such as, e.g., water, through the cooling pipe 11a.

Next, the control method of the regulating hole 6 using the control device 1A for a regulating hole according to the first embodiment and the control principle will be explained.

Initially, direct current I is supplied to the coil 8 of the magnetic field gradient generating means 7 by the power supply 9. Then, as shown in Fig. 2, by this coil 8, the magnetic field gradient will be generated in the radial direction in the tubular passage 3. In Fig. 2, "H" denotes a magnetic field in the tubular passage 3 when direct current I is supplied to the coil 8.

When the magnetic field gradient is generated, the force will work on a number of magnetic particles in the partition wall 5 in the direction of the magnetic field gradient (this force is called "Kelvin force"). This causes elastic deformation of the partition wall 5, which in turn causes accumulation of elastic restoring force in the partition wall 5. The deformation of the partition wall 5 will continue until the Kelvin force working on the magnetic particles and the elastic restoring force accumulated in the partition wall 5 balance out. In accordance with the deformation of the partition wall 5, the opening degree (i.e., the opening area) of the regulating hole 6 changes.

The magnitude of the magnetic field gradient generated in the radial direction in the tubular passage 3 can be easily changed by increasing/decreasing the supply current I to the coil 8.

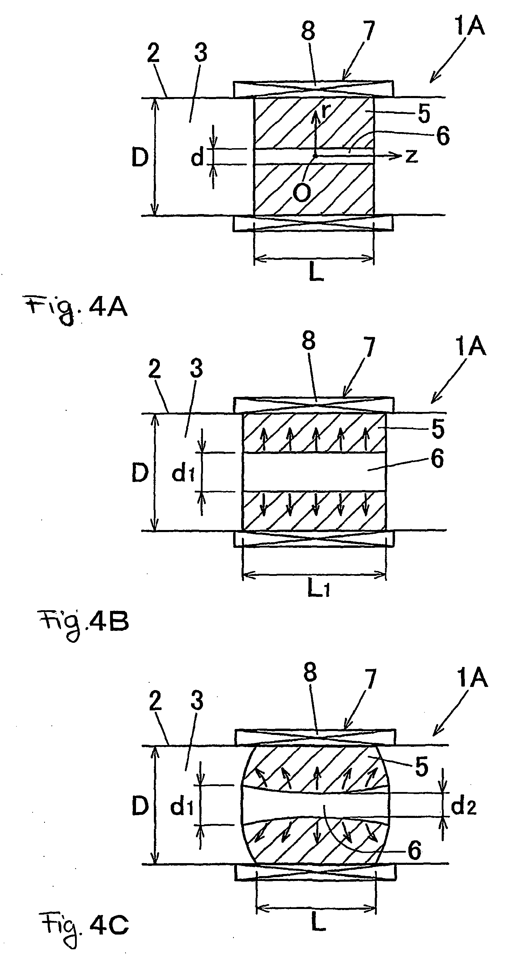

Now, the change of the opening degree of the regulating hole 6 will be explained with reference to Figs. 4A to 4C as follows.

Fig. 4A is a schematic cross-sectional view of the control device 1A showing the partition wall 5 in a state before generating magnetic field gradient in the tubular passage 3.

In the control device 1A shown in Fig. 4A, it is assumed that the partition wall 5 is disposed in the tubular passage 3 such that the circumferential surface thereof is in non-press-fit contact with the circumferential surface of the tubular passage 3 (i.e., the inner circumferential surface of the tubular member 2). In this case, when direct current I is supplied to the coil 8, for example, as shown in Fig. 4B, a number of magnetic particles in the partition wall 5 start moving toward the peripheral side of the tubular passage 3 by the Kelvin force. As a result, the diameter of the regulating hole 6 increases from d to d1 (d<d1) and the partition wall 5 is deformed so that the length extends in the axial direction from L to L1 (L<L1) while slidably moving the circumferential surface of the partition wall 5 on the circumferential surface of the tubular passage 3. In a state after the deformation of the partition wall 5, the diameter d1 of the regulating hole 6 is generally constant in the axial direction. This diameter d1 increases in accordance with the increase of the supply current I to the coil 8. On the other hand, this diameter d1 decreases in accordance with the decrease of the supply current I to the coil 8. When the current supply to the coil 8 is stopped, the diameter d1 returns to the original size d.

On the other hand, in the control device 1A shown in Fig. 4A, it is assumed that the partition wall 5 is disposed in the tubular passage 3 in a state in which the circumferential surface is bonded to the circumferential surface of the tubular passage 3 with adhesive agent. In this case, when direct current I is supplied to the coil 8, for example, as shown in Fig. 4C, a number of magnetic particles in the partition wall 5 start moving toward the peripheral side of the tubular passage 3 by the Kelvin force. As a result, the diameter of the axial both end portions of the regulating hole 6 increases from d to d1 (d<d1) and the diameter of the axial intermediate portion of the regulation hole 6 increases from d to d2 (d<d2). Furthermore, the partition wall 5 is deformed so that it slightly expands in the axial direction, etc., with the circumferential surface is bonded to the circumferential surface of the tubular passage 3. In a state after the deformation of the partition wall 5, the diameter of the regulating hole 6 becomes minimum at the axial intermediate position (the diameter is d2), and gradually increases as it advances from the axial intermediate position to the axial both end portions (the diameter is d1) (that is d1>d2). The diameters d1 and d2 increase in accordance with the increase of the supply current I to the coil 8. On the other hand, this diameters d1 and d2 decrease in accordance with the decrease of the supply current I to the coil 8. When the current supply to the coil 8 is stopped, the diameters d1 and d2 return to the original size d.

On the other hand, in the control device 1A shown in Fig. 4A, it is assumed that the partition wall 5 is disposed in a state in which the circumferential surface of the partition wall 5 is pressurized against the circumferential surface of the tubular passage 3 by the elastic restoring force accumulated in the partition wall 5 and secured thereto by, for example, being inserted into the tubular passage 3 in a compressed state. In this case, the partition wall 5 will be deformed into a shape obtained by combining the deformation of the partition wall 5 shown in Fig. 4B and the deformation of the partition wall 5 shown in Fig. 4C. As the supply current I to the coil 8 increases, the diameter of the regulating hole 6 increases. On the other hand, as the supply current I to the coil 8 decreases, the diameter decreases. When the current supply to the coil 8 stops, the diameter will return to the original size d.

As explained above, in the regulating hole control device 1A of the first embodiment, changing the magnitude of the magnetic field gradient in the radial direction in the tubular passage 3 by increasing/decreasing the supply current I to the coil 8 with the current regulating means 10 causes increase/decrease of the opening degree (opening area) of the regulating hole 6. This enables regulation of the flow rate or pressure of the fluid G passing through the tubular passage 3.

In the control method of the regulating hole 6 using the regulating hole control device 1A of the first embodiment, the opening degree of the regulating hole 6 is changed by generating the magnetic field gradient in the radial direction in the tubular passage 3. Therefore, even if the opening degree of the regulating hole 6 is changed repeatedly, almost no friction of the partition wall 5 will occur. Furthermore, the partition wall 5 is formed by a viscoelastic solid, which does not cause volatilization or vaporization. Therefore, the regulating hole 6 can be controlled over a long period of time.

Furthermore, the partition wall 5 formed by a viscoelastic solid is easy to handle as compared with a partition wall formed by fluid, and the installation work of the partition wall 5 in the tubular passage 3 can be easily performed.

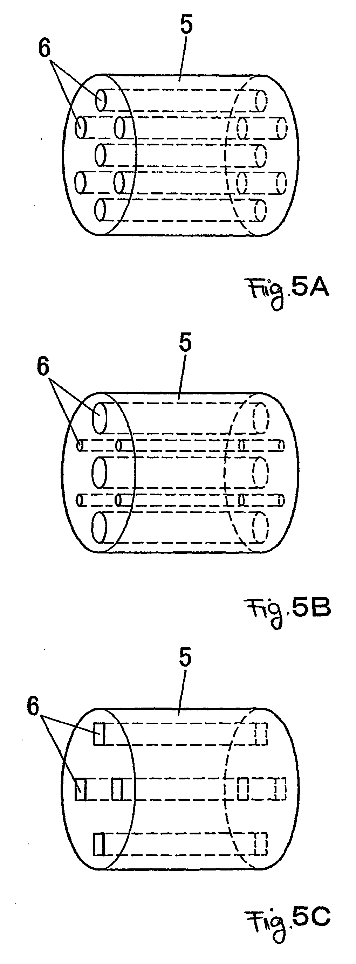

Figs. 5A to 5G show modifications of the regulating hole 6 of the partition wall 5. It should be noted that the regulating hole 6 of the partition wall 5 is not limited to the examples shown in Figs. 5A to 5G, and can be, for example, combination thereof or can be formed into any other shape.

In the example shown Fig. 5A, a plurality of regulating holes 6 are formed so that each penetrates straightly the partition wall 5 in the axial direction. The sizes of the opening areas of the plurality of regulating hole 6 are set to be the same with each other and constant along the axial direction. The cross-sectional shape of each regulating hole 6 is circular. In the present invention, the cross-sectional shape of the regulating hole 6 can be, for example, an elliptical shape.

In the example shown in Fig. 5B, a plurality of regulating holes 6 are formed so that each penetrates straightly the partition wall 5 in the axial direction. There are two sizes of opening areas of the plurality of regulating hole 6 and each opening area is constant along the axial direction. The cross-sectional shape of each regulating hole 6 is circular. In the present invention, the cross-sectional shape of the regulating hole 6 can be, for example, an elliptical shape.

In the example shown in Fig. 5C, a plurality of regulating holes 6 are formed so that each penetrates straightly the partition wall 5 in the axial direction. The sizes of the opening areas of the plurality of regulating hole 6 are set to be the same with each other and constant along the axial direction. The cross-sectional shape of each regulating hole 6 is quadrilateral. In the present invention, the cross-sectional shape of the regulating hole 6 can be, for example, a polygonal shape, such as, e.g., a triangular shape, a pentagonal shape, or a hexagonal shape.

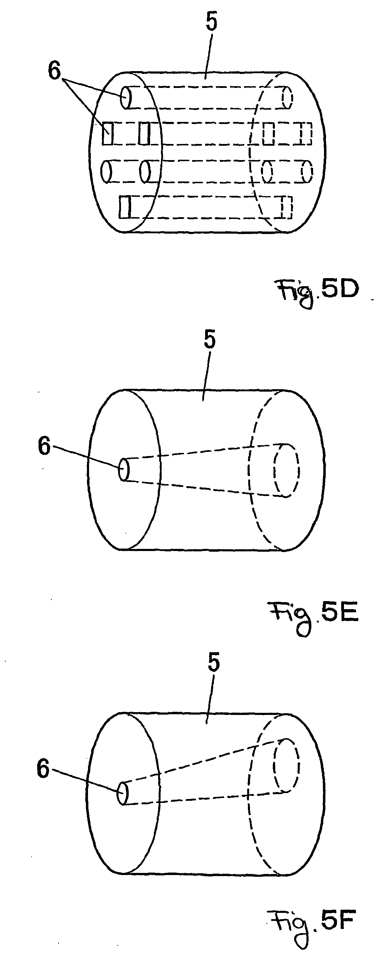

In the example shown in Fig. 5D, a plurality of regulating holes 6 are formed so that each penetrates straightly the partition wall 5 in the axial direction. Some of the plurality of the regulating holes 6 are formed into a circular shape in cross-section and the others are formed into a rectangular shape in cross-section. The opening area of each regulating hole 6 is set to be constant in the axial direction.

In the example shown in Fig. 5E, a regulating hole 6 which is a tapered hole is formed so that it penetrates straightly the partition wall 5 in the axial direction. This regulating hole 6 is a tapered hole in which the opening area gradually increases in the axial direction. In the present invention, the regulating hole 6 can be formed into a shape in which the opening area gradually decreased in the axial direction.

In the example shown in Fig. 5F, a regulating hole 6 which is a tapered hole is formed so that it penetrates the regulating hole 6 in an oblique direction with respect to the axial direction. This regulating hole 6 is a tapered hole in which the opening area gradually increases in the axial direction. In the present invention, the regulating hole 6 can be formed, for example, so that the opening area gradually decreases in the axial direction.

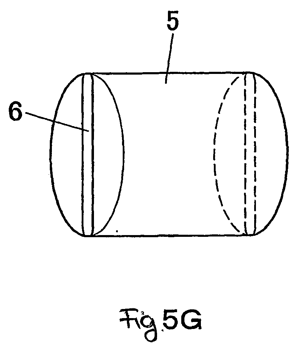

In the example shown in Fig. 5G, an elongated slit-like regulating hole 6 extending in the direction of the diameter is formed so that it penetrates the partition wall 5 in the axial direction. By this regulating hole 6, the partition wall 5 is divided into two pieces.

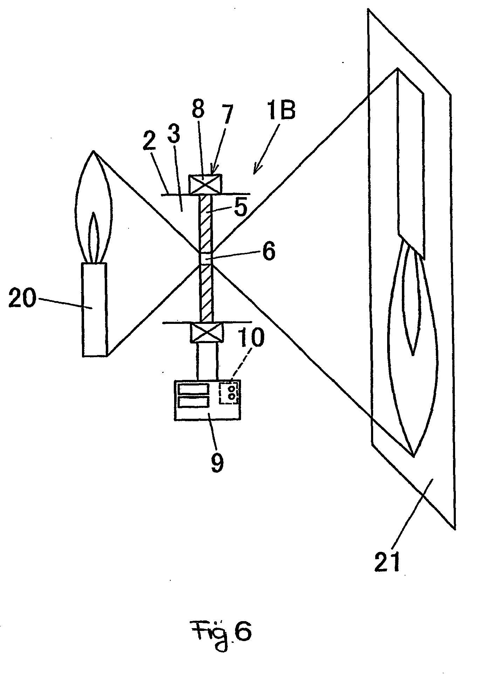

Fig. 6 is an explanatory view for explaining the regulating hole control device 1B according to the second embodiment of the present invention. In this figure, the same reference numeral is allotted to the same element as in the control device 1A of the first embodiment. Hereinafter, the structure of this control device 1B will be explained focusing on the points different from the control device 1A of the first embodiment.

In this control device 1B, light passes through the tubular passage 3 of the tubular member 2 in the axial direction. Specifically, the tubular member 2 is a tubular member round in cross-section. The partition wall 5 is a round plate-shaped member transversely disposed in the tubular passage 3. At the central portion of the partition wall 5, a regulating hole 6 for regulating the amount of light passing through the tubular passage 3 is formed so that it straightly penetrates in the axial direction. The cross-sectional shape of this regulating hole 6 is round. The control device 1B of the second embodiment controls the regulating hole 6. This regulating hole 6 functions as, for examples, an iris.

This control device 1B is used as, for example, an aperture device of an image-taking apparatus, such as, e.g., a camera. "20" denotes an object, and "21" denotes a screen, such as, e.g., a light-sensitive surface.

The control method of the regulating hole 6 using this control device 1B is the same as in the aforementioned first embodiment. The following is a brief explanation thereof.

Direct current is supplied to the coil 8 of the magnetic field gradient generating means 7 by the power source 9 to thereby generate the magnetic field gradient in the radial direction in the tubular passage 3. With this, the opening degree (opening area) of the regulating hole 6 of the partition wall 5 is increased, which in turn increases the amount of light which reaches the screen 21. On the other hand, when the supply current to the coil 8 is decreased, the opening degree of the regulating hole 6 will decrease, which in turn decreases the amount of light which reaches the screen 21.

As explained above, in this control device 1B, the magnitude of the magnetic field gradient in the radial direction in the tubular passage 3 is changed by regulating the supply current to the coil 8 to thereby increase/decrease the opening degree of the regulating hole 6. Thus, the amount of light passing through the tubular passage 3 can be regulated.

Although several embodiments of the present invention were explained, the present invention is not limited to the aforementioned embodiments and allows various modifications within the scope of the appended claims.

For example, in the present invention, the current I to be supplied to the coil 8 of the magnetic field gradient generating means 7 can be, for example, alternating current (e.g., low frequency alternating current) or pulsating current, as well as direct current.

In the present invention, the method of controlling the supply current I to the coil 8 can be a method in which the control is performed by repeating On and Off operations of the current supply switch provided at the power source 9, etc., in a predetermined cycle, i.e., an on-off control method. Alternatively, the method can be a method in which the supply current I to the coil 8 is gradually increased or decreased in terms of time while alternatively repeating the increase and the decrease in a predetermined cycle, or any other methods.

In the present invention, the magnetic field gradient generating means 7 can be constituted by, other than the coil 8, for example, a permanent magnet or an electric magnet disposed at the outside of the tubular passage 3 (i.e., at the outside of the tubular member 2) which generates magnetic field gradient in the radial direction in the tubular passage 3. In this case, by approaching the permanent magnet or the electric magnet to, for example, the tubular passage 3, moving in the axial direction of the tubular passage 3, moving in the circumferential direction, or rotating, the opening degree of the regulating hole 6 can be increased/decreased.

Furthermore, in the present invention, the cross-sectional shape of the tubular passage 3 can be, other than a circular shape, for example, a polygonal shape, such as, e.g., a square shape or a hexagonal shape, or any other shape.

In the present invention, the magnetic particles can be contained in the viscoelastic solid in an evenly dispersed manner or unevenly dispersed manner.

### EXAMPLE

Next, examples (experimental examples) performed experiments on whether the regulating hole control device according to the present invention can regulate the flow rate of fluid will be explained. It should be noted, however, that the present invention is not limited to these examples.

### <STRUCTURE OF CONTROL DEVICE (1C)>

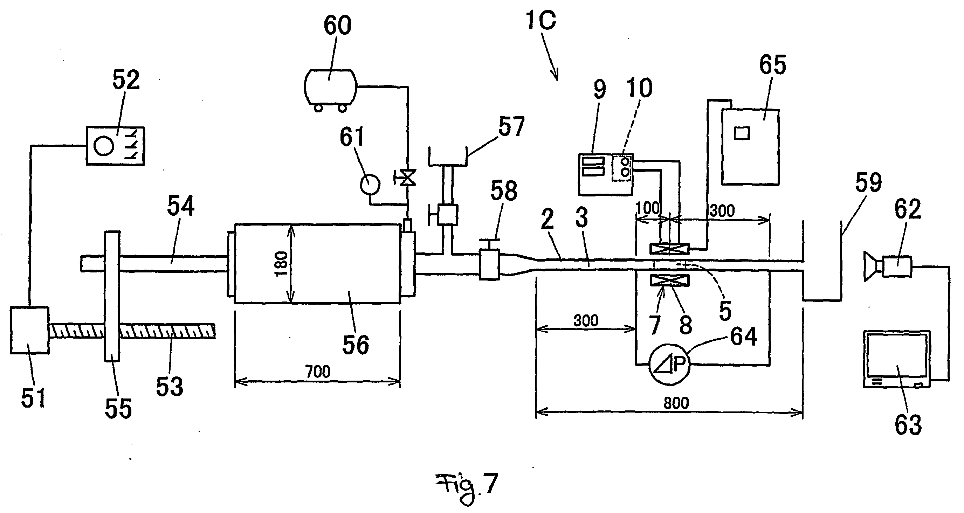

Fig. 7 is a schematic view of a regulating hole control device 1C used in this example (experimental example). In this control device 1C, the diameter D (see Fig. 2) of the tubular passage 3 of the tubular member 2 was 12 mm. The tubular member 2 was made of transparent acrylate resin and had 1 to 2 mm in thickness. The length L of the partition wall 5 was 12 mm. The regulating hole 6 was, as shown in Fig. 3, formed at the center portion of the partition wall 5 so that it penetrated straightly the partition wall 5 in the axial direction of the tubular passage 3. The diameter d of the regulating hole 6 was 1.0 mm.

In this control device 1C, "51" denotes an electric motor, "52" denotes a speed controller, "53" denotes a ball screw, "54" denotes a piston rod, "55" denotes a connection plate, "56" denotes a cylinder, "57" denotes a supply tank, "58" denotes a flow regulating valve, "59" denotes a storage tank, "60" denotes an air compressor, "61" denotes a pressure indicator, "62" denotes a video camera, "63" denotes a monitor, "64" denotes a differential pressure sensor, and "65" denotes a controller for a cooling means for cooling the coil 8. The unit of the numerals shown in Fig. 7 is "mm."

The partition wall 5 was formed by a viscoelastic solid containing ferromagnetic particles having the following materials.

### <Materials of the partition wall 5>

Magnetic particle: carbonyl iron particle (made by BASF, the brand name: "CM")
Particle size of the magnetic particle: see Table 1
Particle density of the magnetic particles: 3.7 x 10³ kg/m³ Magnetism of the magnetic particle: ferromagnetism
Shape of the magnetic particle: spherical shape
Viscoelastic solid: silicone gel (made by Dow Corning Toray Co., Ltd., the brand name: "SE1885A&B")
Viscosity of the viscoelastic solid: 0.5 Pa·s
Density of the viscoelastic solid: 1.0 x 10³kg/m³

The aforementioned characteristics of the magnetic particle and the viscoelastic solid were measured at 25 °C.

The partition wall 5 was produced by the following production method.

### <PRODUCTION METHOD OF THE PARTITION WALL 5>

A mother liquid of silicone gel (brand name: "SE1885A"), its hardening solution (brand name: "SE1885B"), and carbonyl iron particles were uniformly agitated and mixed at the compounding ratio shown in Table 1 with an agitation mixer while defoaming under reduced pressure. Thereafter, this mixture was poured into a molding cavity of an acrylic forming die. At this time, in the molding cavity, a thin rod-shaped core for forming a regulating hole was disposed along the axial direction. Next, the mixture in the molding cavity was heated to be hardened in the temperature range of 30 to 70°C with a hot-air heater. Thereafter, the hardened material was taken out from the molding cavity to thereby produce the desired partition wall 5.

In the partition wall 5 produced as mentioned above, the rate of content of carbonyl iron particles (unit: volume %) was shown in Table 1. The rate of content was calculated by [A/(A+B)]x100, where the volume of the carbonyl iron particles is A and the volume of silicone gel is B.

**[TABLE 1]**

| | Magnetic particle | Particle size (µm) | Viscoelastic solid | Compounding ratio | Rate of content (volume %) |
|---|---|---|---|---|---|
| Example 1 | carbonyl iron particle | 7 | Silicone gel | 1:1:8 | 51.6 |
| Example 2 | carbonyl iron particle | 7 | Silicone gel | 1:1:3 | 28.6 |
| Example 3 | carbonyl iron particle | 7 | Silicone gel | 1:1:4.7 | 38.4 |
| Example 4 | carbonyl iron particle | 7 | Silicone gel | 1:1: 1.3 | 15.1 |
| Example 5 | carbonyl iron particle | 7 | Silicone gel | 1:1:2 | 20.9 |
| Example 6 | carbonyl iron particle | 500 | Silicone gel | 1:1:8 | 51.6 |
| Example 7 | carbonyl iron particle | 1 | Silicone gel | 1:1:8 | 51.6 |

### <CONTROL TEST OF REGULATING HOLE>

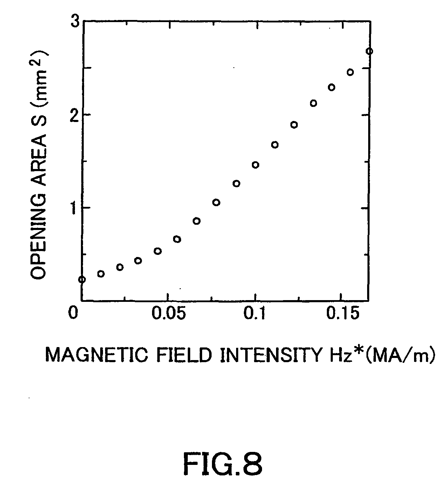

Partition walls 5 of Examples 1 to 7 shown in Table 1 were prepared. Each partition wall 5 was disposed in the tubular passage 3 of the control device 1C. Next, direct current I was supplied to the coil 8 of the magnetic field gradient generating means 7 within the range of 0 to 30 A, and the relationship between the representative magnetic field strength Hz* in the tubular passage 3 and the opening area S of the regulating hole 6 was measured. An example of the result is shown by a graph in Fig. 8. Fig. 8 shows the case in which the partition wall 5 of Example 2 shown in Table 1 was used.

In Fig. 8, Hz* is a representative magnetic field intensity in the tubular passage 3 at the origin O of the z-axis, or the magnetic field intensity at the axial intermediate position of the partition wall 5 on the center axis of the tubular passage 3. Here, when direct current of 0, 10, 20 and 30 A was supplied to the coil 8, Hz* was 0, 0.0556, 0.1112, and 0.1668 MA/m.

As shown in Fig. 8, as the Hz* was increased by increasing the supply current I to the coil 8, the opening area S of the regulating hole 6 was increased. On the other hand, as the Hz* was decreased by decreasing the supply current I to the coil 8, the opening area S of the regulating hole 6 was decreased. Therefore, it was confirmed that the opening degree (opening area S) of the regulating hole 6 could be changed by increasing/decreasing the supply current I to the coil 8.

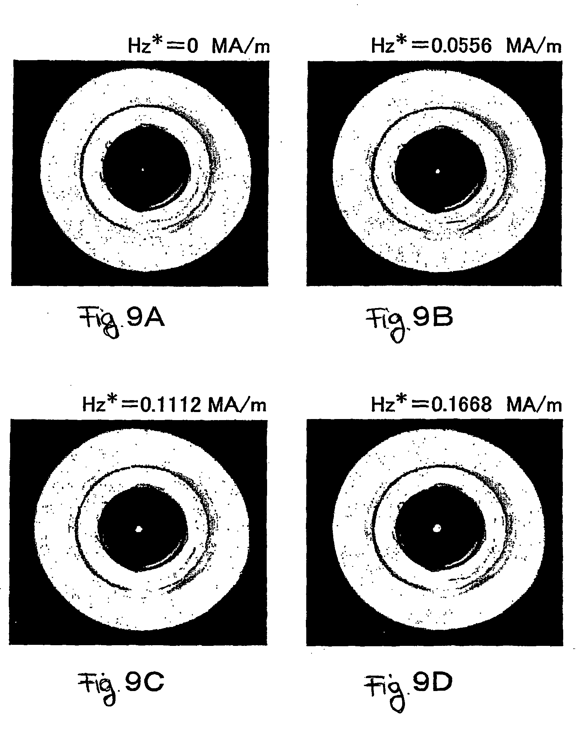

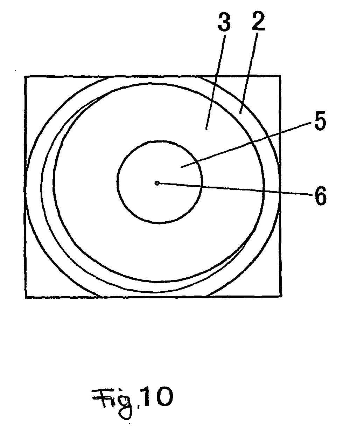

Figs. 9A to 9D show photographs showing the regulating hole 6 of the partition wall 5 taken by the video camera 62 in the case of Hz*=0 MA/m (1=0 A), Hz*=0.0556 MA/m (I=10 A), Hz*=0.1112 MA/m (I=20 A), and Hz*=0.1668 MA/m (I=30 A) (see Fig. 10). From these figures (photographs), it was confirmed that as the Hz* increases, the opening degree (opening area S) of the regulating hole 6 increases and that as the Hz* decreases, the opening degree (opening area S) of the regulating hole 6 decreases.

Actually, while supplying air as fluid from the upstream side into the tubular passage 3 of the control device 1C, the supply current I to the coil 8 was increased and decreased. As a result, in each partition wall of all Examples shown in Table 1, the flow rate of air could be regulated, and further the pressure of the air could also be regulated. Also in the case of using water in place of air as fluid, in the same manner, the flow rate of water could be regulated and further the water pressure could also be regulated.

It should be understood that the terms and expressions used herein are used for explanation and have no intention to be used to construe in a limited manner, do not eliminate any equivalents of features shown and mentioned herein, and allow various modifications falling within the claimed scope of the present invention.

### INDUSTRIAL APPLICABILITY

The present invention can be applied to a control method for a regulating hole and a control device for a regulating hole for regulating the amount of light, the flow rate of fluid and the pressure of fluid passing through a tubular passage.

## Claims

1. A method of controlling a regulating hole, wherein a partition wall (5) is transversely disposed in a tubular passage (3) through which light or fluid (G) passes, the partition wall (5) being provided with a regulating hole (6) for regulating an amount of the light, a flow rate of the fluid, or a pressure of the fluid so that the regulating hole (6) penetrates the partition wall (5) in an axial direction, and
wherein magnetic field gradient is generated in a radial direction in the tubular passage (3) to thereby change an opening degree of the regulating hole (6), **characterized in that**
the partition wall (5) is formed by a viscoelastic solid containing magnetic particles being dispersed in the viscoelastic solid and contained in the viscoelastic solid in a fixed manner.

2. The method of controlling a regulating hole as recited in claim 1, wherein the magnetic particle is set to 500 µm or less in particle size.

3. The method of controlling a regulating hole as recited in claim 1, wherein the viscoelastic solid is one type or two or more types of rubbers selected from the group consisting of silicone rubber, urethane rubber, propylene rubber, polyethylene rubber, neoprene rubber, and natural rubber.

4. The method of controlling a regulating hole as recited in claim 1, wherein the magnetic particle is one type or two or more types of particles selected from the group consisting of carbonyl iron particles, ferrite particles, and magnetite particles.

5. The method of controlling a regulating hole as recited in claim 1, wherein, when a value obtained by dividing a volume of the magnetic particles by a total volume of the magnetic particles and the viscoelastic solid is defined as a rate of content of the magnetic particles in the partition wall, the rate of content is set so as to fall within the range of 15 to 52 volume %.

6. The method of controlling a regulating hole as recited in claim 1, wherein the partition wall is formed by a silicone rubber containing carbonyl iron particles obtained by mixing mother liquid of the silicone rubber, its hardening solution, and carbonyl iron particles falling within the range of 1 : 0.1-1.5 : 1.3-8 in mass ratio and then heat hardening the mixture.

7. The method of controlling a regulating hole as recited in claim 1, wherein the magnetic field gradient is generated by a coil disposed at an outside of the tubular passage so as to surround the partition wall in a circumferential direction.

8. A control device (1B, 1C) for a regulating hole, comprising:
a tubular passage (3) through which light or fluid (G) passes;
a partition wall (5) transversely disposed in the tubular passage (3) and provided with a regulating hole (6) for regulating an amount of the light, a flow rate of the fluid, or a pressure of the fluid so that the regulating hole (6) penetrates the partition wall (5) an axial direction; and
a magnetic field gradient generating means (7) for generating magnetic field gradient in a radial direction in the tubular passage (3), **characterized in that**
the partition wall (5) is formed by a viscoelastic solid containing magnetic particles being dispersed in the viscoelastic solid and contained in the viscoelastic solid in a fixed manner.

9. The control device for a regulating hole as recited in claim 8, wherein the magnetic particle is set to be 500 µm or less in particle size.

10. The control device (1B, 1C) for a regulating hole as recited in claim 8, wherein the viscoelastic solid is one type or two or more types of rubbers selected from the group consisting of silicone rubber, urethane rubber, propylene rubber, polyethylene rubber, neoprene rubber, and natural rubber.

11. The control device (1B, 1C) for a regulating hole as recited in claim 8, wherein the magnetic particle is one type or two or more types of particles selected from the group consisting of carbonyl iron particles, ferrite particles, and magnetite particles.

12. The control device (1B, 1C) for a regulating hole as recited in claim 8, wherein, when a value obtained by dividing a volume of the magnetic particles by a total volume of the magnetic particles and the viscoelastic solid is defined as a rate of content of the magnetic particles in the partition wall, the rate of content is set so as to fall within the range of 15 to 52 volume %.

13. The control device (1B, 1C) for a regulating hole as recited in claim 8, wherein the partition wall is formed by a silicone rubber containing carbonyl iron particles obtained by mixing mother liquid of the silicone rubber, its hardening solution, and carbonyl iron particles falling within the range of 1 : 0.1-1.5 : 1.3-8 in mass ratio and then heat hardening the mixture.

14. The control device (1B, 1C) for a regulating hole as recited in claim 8, wherein the magnetic field gradient generating means is configured to generate magnetic field gradient by a coil disposed at an outside of the tubular passage so as to surround the partition wall in a circumferential direction.

15. A method of producing a partition wall (5) for use in a control device (1B, 1C) for a regulating hole, the control device comprising:
a tubular passage (3) through which light or fluid (G) passes;
a partition wall (5) transversely disposed in the tubular passage (3) and provided with a regulating hole (6) for regulating an amount of the light, a flow rate of the fluid, or a pressure of the fluid so that the regulating hole (6) penetrates the partition wall (5) an axial direction; and
a magnetic field gradient generating means (7) for generating magnetic field gradient in a radial direction in the tubular passage (3), **characterized in that**
the partition wall (5) is formed by a viscoelastic solid containing magnetic particles being dispersed in the viscoelastic solid and contained in the viscoelastic solid in a fixed manner, wherein the partition wall (5) is formed by silicone rubber containing carbonyl iron particles obtained by mixing mother liquid of the silicone rubber, its hardening solution, and carbonyl iron particles falling within the range of 1: 0.1-1.5 : 1.3-8 in mass ratio and then heat hardening the mixture.

## Patentansprüche

1. Ein Verfahren zum Steuern eines Regulierungslochs, wobei eine Trennwand (5) quer in einem rohrförmigen Durchgang (3) angeordnet wird, durch den Licht oder Fluid (G) hindurchströmt, wobei die Trennwand (5) mit einem Regulierungsloch (6) versehen wird, um eine Menge des Lichts, eine Durchflussrate des Fluids oder einen Druck des Fluids zu regulieren, so dass das Regulierungsloch (6) die Trennwand (5) in einer Axialrichtung durchringt, und
wobei in einer radialen Richtung in dem rohrförmigen Durchgang (3) ein Magnetfeldgradient erzeugt wird, um **dadurch** einen Öffnungsgrad des Regulierungslochs (6) zu ändern, **dadurch gekennzeichnet, dass**
die Trennwand (5) durch einen viskoelastischen Feststoff ausgebildet wird, der Magnetteilchen enthält, die in dem viskoelastischen Feststoff dispergiert sind und auf feste Weise in dem viskoelastischen Feststoff enthalten sind.

2. Das Verfahren zum Steuern eines Regulierungslochs gemäß Anspruch 1, wobei das Magnetteilchen auf eine Teilchengröße von 500 µm oder weniger festgesetzt wird.

3. Das Verfahren zum Steuern eines Regulierungslochs gemäß Anspruch 1, wobei der viskoelastische Feststoff eine. Art oder zwei oder mehr Arten von Kautschuken ist, die aus der Gruppe bestehend aus Silikonkautschuk, Urethankautschuk, Propylenkautschuk, Polyethylenkautschuk, Neoprenkautschuk und Naturkautschuk ausgewählt werden.

4. Das Verfahren zum Steuern eines Regulierungslochs gemäß Anspruch 1, wobei das Magnetteilchen eine Art oder zwei oder mehr Arten von Teilchen ist, die aus der Gruppe bestehend aus Carbonyleisenteilchen, Ferritteilchen und Magnetitteilchen ausgewählt werden.

5. Das Verfahren zum Steuern eines Regulierungslochs gemäß Anspruch 1, wobei, wenn ein durch Dividieren eines Volumens der Magnetteilchen durch ein Gesamtvolumen der Magnetteilchen und des viskoelastischen Feststoffes erhaltener Wert als eine Gehaltsrate der Magnetteilchen in der Trennwand definiert wird, die Gehaltsrate derart festgesetzt wird, dass sie in den Bereich von 15 bis 52 Volumenprozent fällt.

6. Das Verfahren zum Steuern eines Regulierungslochs gemäß Anspruch 1, wobei die Trennwand durch einen Carbonyleisenteilchen enthaltenden Silikonkautschuk gebildet wird, der durch Mischen von Mutterflüssigkeit des Silikonkautschuks, seiner Verfestigungslösung und von Carbonyleisenteilchen mit einem Massenverhältnis im Bereich von 1 : 0,1-1,5 : 1,3-8 und durch anschließendes Wärmeverfestigen des Gemischs erhalten wird.

7. Das Verfahren zum Steuern eines Regulierungslochs gemäß Anspruch 1, wobei der Magnetfeldgradient durch eine Spule erzeugt wird, die an einer Außenseite des rohrförmigen Durchgangs angeordnet wird, um die Trennwand in einer Umfangsrichtung zu umgeben.

8. Eine Steuervorrichtung (1B, 1C) für ein Regulierungsloch, aufweisend:
einen rohrförmigen Durchgang (3), durch den Licht oder Fluid (G) hindurchströmt,
eine Trennwand (5), die quer in dem rohrförmigen Durchgang (3) angeordnet ist und mit einem Regulierungsloch (6) versehen ist, um eine Menge des Lichts, eine Durchflussrate des Fluids oder einen Druck des Fluids zu regulieren, so dass das Regulierungsloch (6) die Trennwand (5) in einer Axialrichtung durchdringt, und
ein Magnetfeldgradient-Erzeugungsmittel (7) zum Erzeugen eines Magnetfeldgradienten in einer radialen Richtung in dem rohrförmigen Durchgang (3), **dadurch gekennzeichnet, dass**
die Trennwand (5) durch einen viskoelastischen Feststoff ausgebildet ist, der Magnetteilchen enthält, die in dem viskoelastischen Feststoff dispergiert sind und auf feste Weise in dem viskoelastischen Stoff enthalten sind.

9. Die Steuervorrichtung für ein Regulierungsloch gemäß Anspruch 8, wobei das Magnetteilchen auf eine Teilchengröße von 500 µm oder weniger festgesetzt ist.

10. Die Steuervorrichtung (13, 1C) für ein Regulierungsloch gemäß Anspruch 8, wobei der viskoelastische Feststoff eine Art oder zwei oder mehr Arten von Kautschuken ist, die aus der Gruppe bestehend aus Silikonkautschuk, Urethankautschuk, Propylenkautschuk, Polyethylenkautschuk, Neoprenkautschuk und Naturkautschuk ausgewählt sind.

11. Die Steuervorrichtung (1B, 1C) für ein Regulierungsloch gemäß Anspruch 8, wobei das Magnetteilchen eine Art oder zwei oder mehr Arten von Teilchen ist, die aus der Gruppe bestehend aus Carbonyleisenteilchen, Ferritteilchen und Magnetitteilchen ausgewählt sind.

12. Die Steuervorrichtung (1B, 1C) für ein Regulierungsloch gemäß Anspruch 8, wobei, wenn ein durch das Dividieren eines Volumens der Magnetteilchen durch ein Gesamtvolumen der Magnetpartikel und des viskoelastischen Feststoffes erhaltener Wert als eine Gehaltsrate der Magnetteilchen in der Trennwand definiert ist, die Gehaltsrate derart festgesetzt ist, dass sie in einen Bereich von 15 bis 52 Volumenprozent fällt.

13. Die Steuervorrichtung (1B, 1C) für ein Regulierungsloch gemäß Anspruch 8, wobei die Trennwand durch einen Carbonyleisenteilchen enthaltenden Silikonkautschuk gebildet ist, der durch Mischen von Mutterflüssigkeit des Silikonkautschuks, seiner Verfestigungslösung und von Carbonyleisenteilchen mit einem Massenverhältnis im Bereich von 1 : 0,1-1,5 : 1,3-8 und durch anschließendes Wärmeverfestigen der Lösung erhalten wird.

14. Die Steuervorrichtung (1B, 1C) für ein Regulierungsloch gemäß Anspruch 8, wobei das Magnetfeldgradient-Erzeugungsmittel eingerichtet ist, um einen Magnetfeldgradienten durch eine Spule zu erzeugen, die an einer Außenseite des rohrförmigen Durchgangs angeordnet ist, um die Trennwand in einer Umfangsrichtung zu umgeben.

15. Ein Verfahren zum Herstellen einer Trennwand (5) zur Verwendung in einer Steuervorrichtung (1B, 1C) für ein Regulierungsloch, wobei die Steuervorrichtung aufweist:
einen rohrförmigen Durchgang (3), durch den Licht oder Fluid (G) hindurchströmt,
eine Trennwand (5), die quer in dem rohrförmigen Durchgang (3) angeordnet ist und mit einem Regulierungsloch (6) versehen ist, um die Menge des Lichts, eine Durchflussrate des Fluids oder einen Druck des Fluids zu regulieren, so dass das Regulierungsloch (6) die Trennwand (5) in einer Axialrichtung durchdringt, und
ein Magnetfeldgradient-Erzeugungsmittel (7) zum Erzeugen eines Magnetfeldgradienten in einer radialen Richtung in dem rohrförmigen Durchgang (3), **dadurch gekennzeichnet, dass**
die Trennwand (5) durch einen viskoelastischen Feststoff ausgebildet wird, der Magnetteilchen enthält, die in dem viskoelastischen Feststoff dispergiert sind und auf feste Weise in dem viskoelastischen Feststoff enthalten sind, wobei die Trennwand (5) aus Carbonyleisenteilchen enthaltendem Silikonkautschuk gebildet wird, der durch Mischen von Mutterflüssigkeit des Silikonkautschuks, seiner Verfestigungslösung und von Carbonyleisenteilchen in einem Massenverhältnis, das im Bereich von 1 : 0,1-1,5 : 1,3-8 liegt, und durch anschließendes Wärmeverfestigen des Gemischs erhalten wird.

## Revendications

1. Procédé de commande d'un trou de régulation, dans lequel une cloison de séparation (5) est disposée de manière transversale dans un passage tubulaire (3) à travers lequel une lumière ou un fluide (G) passe, la cloison de séparation (5) étant dotée d'un trou de régulation (6) destiné à réguler la quantité de lumière, le débit du fluide ou la pression du fluide de telle sorte que le trou de régulation (6) pénètre dans la cloison de séparation (5) dans une direction axiale ; et
dans lequel un gradient de champ magnétique est généré dans une direction radiale dans le passage tubulaire (3) de façon à modifier de ce fait le degré d'ouverture du trou de régulation (6), **caractérisé en ce que** :
la cloison de séparation (5) est constituée par un solide viscoélastique qui contient des particules magnétiques qui sont dispersées dans le solide viscoélastique et qui sont contenues dans le solide viscoélastique d'une façon fixe.

2. Procédé de commande d'un trou de régulation selon la revendication 1, dans lequel les particules magnétiques présentent une taille de particule égale ou inférieure à 500 µm.

3. Procédé de commande d'un trou de régulation selon la revendication 1, dans lequel le solide viscoélastique est d'un type ou de deux types ou plus de caoutchoucs sélectionnés dans le groupe constitué par le caoutchouc de silicone, le caoutchouc d'uréthane, le caoutchouc de propylène, le caoutchouc de polyéthylène, le caoutchouc de néoprène et le caoutchouc naturel.

4. Procédé de commande d'un trou de régulation selon la revendication 1, dans lequel les particules magnétiques sont d'un type ou de deux types ou plus de particules sélectionnées dans le groupe constitué par des particules d'acier carbonyle, des particules de ferrite et des particules de magnétite.

5. Procédé de commande d'un trou de régulation selon la revendication 1, dans lequel, lorsque la valeur obtenue en divisant le volume des particules magnétiques par le volume total des particules magnétiques et du solide viscoélastique est définie comme étant la teneur en particules magnétiques dans la cloison de séparation, la teneur est fixée de façon à se situer dans une plage comprise entre 15 % et 52 % en volume.

6. Procédé de commande d'un trou de régulation selon la revendication 1, dans lequel la cloison de séparation est constituée par un caoutchouc de silicone qui contient des particules d'acier carbonyle obtenues en mélangeant une solution mère de caoutchouc de silicone, sa solution de durcissement, et des particules d'acier carbonyle à l'intérieur de la plage 1 : 0,1 à 1,5 : 1,3 à 8 en rapport de masse et en thermodurcissant ensuite le mélange.

7. Procédé de commande d'un trou de régulation selon la revendication 1, dans lequel le gradient de champ magnétique est généré par une bobine disposée à l'extérieur du passage tubulaire de façon à entourer la cloison de séparation dans une direction circonférentielle.

8. Dispositif de commande (1B, 1C) d'un trou de régulation, comprenant :
un passage tubulaire (3) à travers lequel une lumière ou un fluide (G) passe ;
une cloison de séparation (5) disposée de manière transversale dans le passage tubulaire (3) et dotée d'un trou de régulation (6) destiné à réguler la quantité de lumière, le débit du fluide ou la pression du fluide de telle sorte que le trou de régulation (6) pénètre dans la cloison de séparation (5) dans une direction axiale ; et
des moyens de génération de gradient de champ magnétique (7) destinés à générer un gradient de champ magnétique dans une direction radiale dans le passage tubulaire (3), **caractérisé en ce que** :
la cloison de séparation (5) est constituée par un solide viscoélastique qui contient des particules magnétiques qui sont dispersées dans le solide viscoélastique et qui sont contenues dans le solide viscoélastique d'une façon fixe.

9. Dispositif de commande (1B, 1C) d'un trou de régulation selon la revendication 8, dans lequel les particules magnétiques présentent une taille de particule égale ou inférieure à 500 µm.

10. Dispositif de commande (1B, 1C) d'un trou de régulation selon la revendication 8, dans lequel le solide viscoélastique est d'un type ou de deux types ou plus de caoutchoucs sélectionnés dans le groupe constitué par le caoutchouc de silicone, le caoutchouc d'uréthane, le caoutchouc de propylène, le caoutchouc de polyéthylène, le caoutchouc de néoprène et le caoutchouc naturel.

11. Dispositif de commande (1B, 1C) d'un trou de régulation selon la revendication 8, dans lequel les particules magnétiques sont d'un type ou de deux types ou plus de particules sélectionnées dans le groupe constitué par des particules d'acier carbonyle, des particules de ferrite et des particules de magnétite.

12. Dispositif de commande (1B, 1C) d'un trou de régulation selon la revendication 8, dans lequel, quand la valeur obtenue en divisant le volume des particules magnétiques par le volume total des particules magnétiques et du solide viscoélastique est définie comme étant la teneur en particules magnétiques dans la cloison de séparation, la teneur est fixée de façon à se situer dans une plage comprise entre 15 % et 52 % en volume.

13. Dispositif de commande (1B, 1C) d'un trou de régulation selon la revendication 8, dans lequel la cloison de séparation est constituée par un caoutchouc de silicone qui contient des particules d'acier carbonyle obtenues en mélangeant une solution mère de caoutchouc de silicone, sa solution de durcissement, et des particules d'acier carbonyle à l'intérieur de la plage 1 : 0,1 à 1,5 : 1,3 à 8 en rapport de masse et en thermodurcissant ensuite le mélange.

14. Dispositif de commande (1B, 1C) d'un trou de régulation selon la revendication 8, dans lequel les moyens de génération de gradient de champ magnétique sont configurés de façon à générer un gradient de champ magnétique à l'aide d'une bobine disposée à l'extérieur du passage tubulaire de façon à entourer la cloison de séparation dans une direction circonférentielle.

15. Procédé de fabrication d'une cloison de séparation (5) destinée à être utilisée dans un dispositif de commande (1B, 1C) d'un trou de régulation, le dispositif de commande comprenant :
un passage tubulaire (3) à travers lequel une lumière ou un fluide (G) passe ;
une cloison de séparation (5) disposée de manière transversale dans le passage tubulaire (3) et dotée d'un trou de régulation (6) destiné à réguler la quantité de lumière, le débit du fluide ou la pression du fluide de telle sorte que le trou de régulation (6) pénètre dans la cloison de séparation (5) dans une direction axiale ; et
des moyens de génération de gradient de champ magnétique (7) destinés à générer un gradient de champ magnétique dans une direction radiale dans le passage tubulaire (3), **caractérisé en ce que** :
la cloison de séparation (5) est constituée par un solide viscoélastique qui contient des particules magnétiques dispersées dans le solide viscoélastique et contenues dans le solide viscoélastique d'une façon fixe, dans lequel la cloison de séparation (5) est constituée par un caoutchouc de silicone qui contient des particules d'acier carbonyle obtenues en mélangeant une solution mère de caoutchouc de silicone, sa solution le durcissement, et des particules d'acier carbonyle à l'intérieur de la plage 1 : 0,1 à 1,5 : 1,3 à 8 en rapport de masse et en thermodurcissant ensuite le mélange.
